# EUROPEAN PATENT APPLICATION

(11) **EP 2 402 284 A1**
(43) Date of publication of application: **04.01.2012**
(21) Application number: 10167760.7
(22) Date of filing: 29.06.2010
(51) Int. Cl.: B81C 1/00

(54) **MEMS manufacturing method**

(71) Applicant: NXP B.V., 5656 AG Eindhoven (NL)
(72) Inventor: Lander, Robert James Pascoe, Redhill, Surrey RH1 1DL (GB); Van Beek, Jozef Thomas Martinus, Redhill, Surrey RH1 1DL (GB); Van Velzen, Bart, Redhill, Surrey RH1 1DL (GB); Koops, Gerhard, Redhill, Surrey RH1 1DL (GB); In'T Zandt, Michael Antoine Armand, Redhill, Surrey RH1 1DL (GB); Falepin, Annelies, Redhill, Surrey RH1 1DL (GB); Boccardi, Guillaume, Redhill, Surrey RH1 1DL (GB)
(74) Representative: Williamson, Paul Lewis

(57) **Abstract**

In a first aspect, the invention provides a MEMS packaging method in which a first sacrificial etch is used to release a MEMS component by removing the sacrificial support layer beneath the MEMS component, and a second sacrificial etch is used to remove a sacrificial cover layer beneath a hermetic cover layer. In a second aspect, the invention provides a MEMS packaging method in which a hermetic cover layer is provided over a sacrificial cover layer which is then removed. A separate reinforcement cap layer is deposited over the hermetic cover layer.

## Description

This invention relates to MEMS devices, and in particular to the formation of packaged devices.

MEMS technologies are increasingly being used in integrated circuits. However, numerous product concepts have not been implemented in practice as a result of difficulties providing suitable and cost effective packaging. Because MEMS devices are fragile as a result of the moving parts, and the device performance is affected by impurities, they have to be protected by such packaging both for the final use of the device but also during wafer dicing and bonding (when individual devices are separated from a substrate on which an array of devices has been formed).

There are many contributing factors to the high costs in packaging of MEMS devices and systems. The three principal factors are:
- proper packaging and efficient assembly of parts and components of sizes less than a few millimetres, with complex geometries, requires special tools and fixtures.
- the high diversity of MEMS devices and systems makes requirements for reliable packaging vary significantly from one product to another. For example, vacuum packing for hermetic sealing is a necessity in many cases.

There are a number of techniques used for encapsulating MEMS devices:
- use of off-the-shelf packages and careful handling techniques;
- attachment of a separate cap, usually glass or silicon, on top of a finished MEMS device part;
- integrated wafer level package (WLP) encapsulation.

The selection of off-the-shelf components is a costly and time-consuming process.

The use of a separate cap requires a capping wafer, which typically comprises a pre-fabricated cavity formed of glass or silicon. Anodic of frit glass bonding is then used, because of the back-end compatible process temperatures (400°C) in preference to fusion bonding at much higher temperatures (1000°C). A vacuum inside the cavity can be achieved if the bonding is performed in a vacuum chamber. This approach requires wafer bonding and flip-chip alignment equipment.

An integrated wafer-level solution involves fabricating caps using standard surface micro machining techniques. This approach consumes less area and the chip height is kept lower than if an independently manufactured cap is used. If the encapsulation is strong enough, the MEMS chip can be further packaged like a normal IC, which is cost effective. Furthermore this allows the possibility of integration with CMOS processes.

In a wafer level encapsulating process, the MEMS structure is built inside a cavity with an encapsulation shell using normal process steps. For most MEMS structures, for instance resonators, the Q-factor increases at lower pressures due to less air-damping. This means that some applications require the encapsulating shell to be hermetic to avoid the Q-factor decreasing over time.

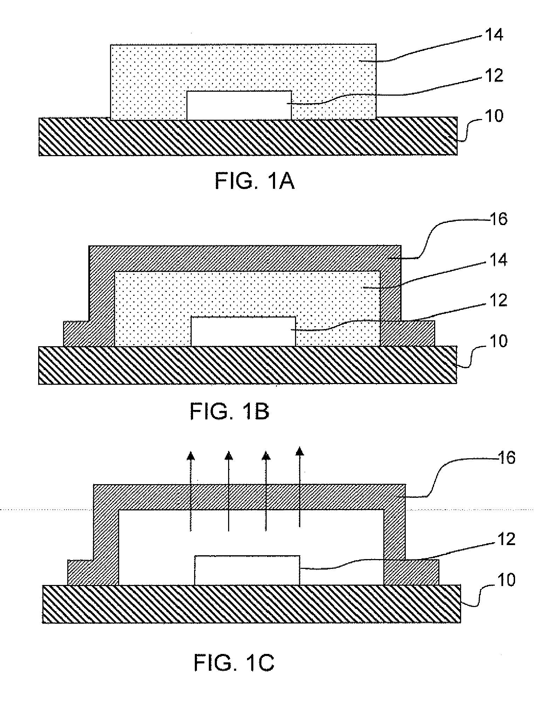

A known WLP construction method makes use of two stacked layers. Simplified schematic cross sections are given in Figures 1A to 1C, which explain the capping process, but do not give any details of the MEMS fabrication or release processes..

The figures show the substrate 10, the MEMS device 12, and a lower layer 14 of sacrificial material. The lower layer 14 is patterned to extend beyond the active MEMS device 12 at all sides. An upper layer 16 consists of a capping material. The upper layer 16 is deposited to cover/encapsulate the bottom layer 14 at all sides as shown in Figure 1B. Layer 16 can be patterned for electrical contact with layer 10 for operating device 12.

The sacrificial material is removed to create a cavity around the MEMS device as shown in Figure 1C. In addition, the removal of the sacrificial layer releases suspended parts of the MEMS device, and thus also forms part of the process of forming the MEMS device. Optionally there are release holes in the upper layer to enable removal of the sacrificial material, which are sealed by a third layer. An example consists of:
- the lower layer 14 of a polymer;
- the upper layer 16 of silicon oxide;
- removal of the polymer material by thermal degradation as represented by arrows in Figure 1C.

A problem with this approach is that the process is not robust to the chip packaging process. This invention relates to an improved integrated approach for forming MEMS device packaging.

According to a first aspect of the invention, there is provided a method of manufacturing a MEMS device, comprising:
forming a MEMS device element by:
   forming and patterning a MEMS layer over a sacrificial support layer to define a component of the MEMS device which is to be suspended; and
   performing a first sacrificial etch to release the MEMS component by removing the sacrificial support layer beneath the MEMS component;
depositing a sacrificial cover layer over the MEMS device element;
depositing and patterning a cover layer over the sacrificial cover layer;
performing a second sacrificial etch to remove the sacrificial cover layer through at least one opening in the cover layer; and
closing the at least one opening in the cover layer thereby defining a hermetic cover.

This method uses two distinct sacrificial layers and two non-sequential sacrificial release steps (the sacrificial cover layer is deposited after the MEMS release sacrificial etch). This provides the decoupling of the requirements of several materials. Specifically, the choice of the materials for the first sacrificial layer is decoupled from that for the cover layer. In particular, the first sacrificial layer (e.g. SiO₂) can be removed using aggressive etchants (e.g. HF) that might attack the preferred choices of the hermetic cover layer (e.g. silicon nitride Si₃N₄, hereafter referred to as SiN) as well as other layers that can be introduced after the first sacrificial etch.

The invention enables a process that provides hermetically sealed devices after standard "back-end" processing (wafer grinding, dicing, mounting, and package overmoulding).

The MEMS layer and sacrificial support layer can be provided over a substrate, wherein the MEMS layer, sacrificial support layer and substrate together define a SOI substrate arrangement. Thus, the packaged MEMS device can be formed over a SOI substrate arrangement. The sacrificial support layer then comprises SiO₂ or SiN.

The sacrificial cover layer can comprise Al, SiO₂, Ti, TiN, Ni, Ta W or WN. The method can further comprise applying or forming a layer on the released MEMS component before depositing the sacrificial cover layer. This can comprise an oxide layer for passivation and/or temperature compensation of the MEMS component.

The formation of a sacrificial cover layer after the formation of a passivation / temperature-compensation layer allows this passivation / temperature -compensation layer to be used layer as an etch stop for the patterning (for example by dry etch) of the sacrificial cover layer. For example, in the case of a metal sacrificial cover layer (e.g. AI, Ti, TiN, Ni, Ta, W, WN), stopping on a Si active MEMS layer is especially challenging.

A reinforcement mechanical cap layer is preferably deposited over the cover layer after closing the at least one opening in the cover layer.

This provides separation of the layer functionalities of hermeticity, and mechanical support between distinct layers. These distinct layers are deposited, respectively, before and after hermetic sealing. This allows the requirements of these two layers to be decoupled. Thus, the reinforcement layer may be permitted to outgas and need not provide a hermetic seal. The hermetic layer need not be very thick and this enables smaller sealing holes that are readily sealed with standard high vacuum deposition techniques (e.g. plasma sputtering).

In a second aspect, the invention provides a method of manufacturing a MEMS device, comprising:
forming a MEMS device element;
depositing a sacrificial cover layer over the MEMS device element;
depositing and patterning a cover layer over the sacrificial cover layer;
performing a second sacrificial etch to remove the sacrificial cover layer through at least one opening in the cover layer;
closing the at least one opening in the cover layer thereby defining a hermetic cover; and
depositing a reinforcement cap layer over the cover layer after closing the at least one opening in the cover layer.

This method provides the separation of the layer functionalities of hermeticity, and mechanical support between distinct layers, as discussed above. The method can be used generally, and is not limited to the sacrificial layer arrangement of the first aspect of the invention.

In both aspects of the invention, the hermetic cover layer can comprise SiN, SiC, Si or Ge. Closing the at least one opening in the hermetic cover layer can comprise depositing a hermetic seal layer of AI, Ti, W, AIN, TiN, WN, Si, Ge or SiC. The hermetic seal layer can also define electrical contact regions to the MEMS device element, and the seal layer then preferably comprises AI, Ti, W, AIN, TiN, or WN.

The reinforcement cap layer can comprise SiN, SiO₂, BPSG or polyimide.

The invention provides a method of forming a packaged MEMS device element. The invention can be applied for example to MEMS devices which comprise a switch, capacitor or resonator.

The invention also provides a MEMS device, comprising:
a MEMS device element;
a cover layer over the MEMS device element, with a MEMS device element in a chamber beneath the cover layer, wherein the cover layer has at least one closed opening such that the cover layer and closed opening defines a hermetic cover; and
a reinforcement cap layer over the cover layer.

Examples of the invention will now be described with reference to the accompanying drawings, in which:
Figure 1 shows a known wafer level encapsulation process;
Figure 2 shows a first example of wafer level encapsulation process of the invention; and
Figure 3 shows a second example of wafer level encapsulation process of the invention.

In a first aspect, the invention provides a MEMS packaging method in which a first sacrificial etch is used to release a MEMS component by removing the sacrificial support layer beneath the MEMS component, and a second sacrificial etch is used to remove a sacrificial cover layer beneath a cover layer. In a second aspect, the invention provides a MEMS packaging method in which a cover layer is provided over a sacrificial cover layer which is then removed. A separate mechanical cap layer is deposited over the hermetic cover layer.

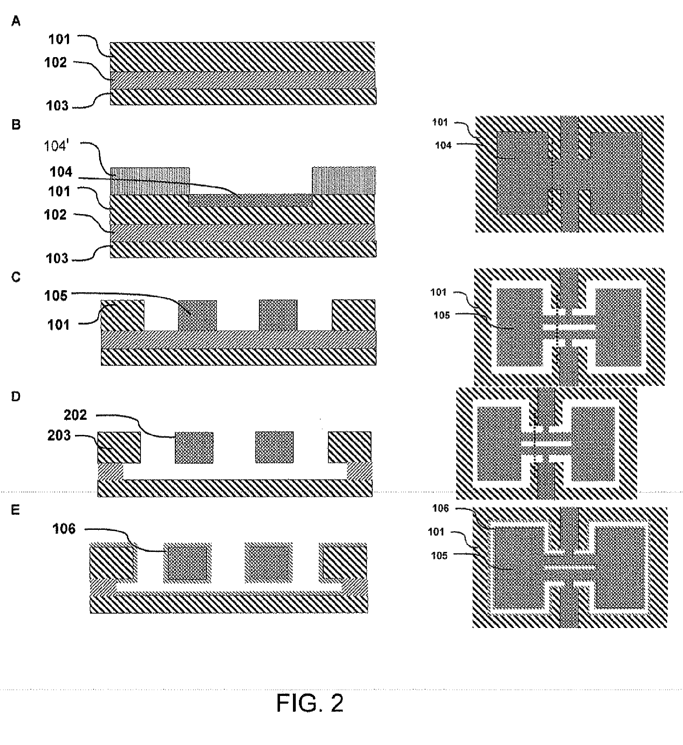

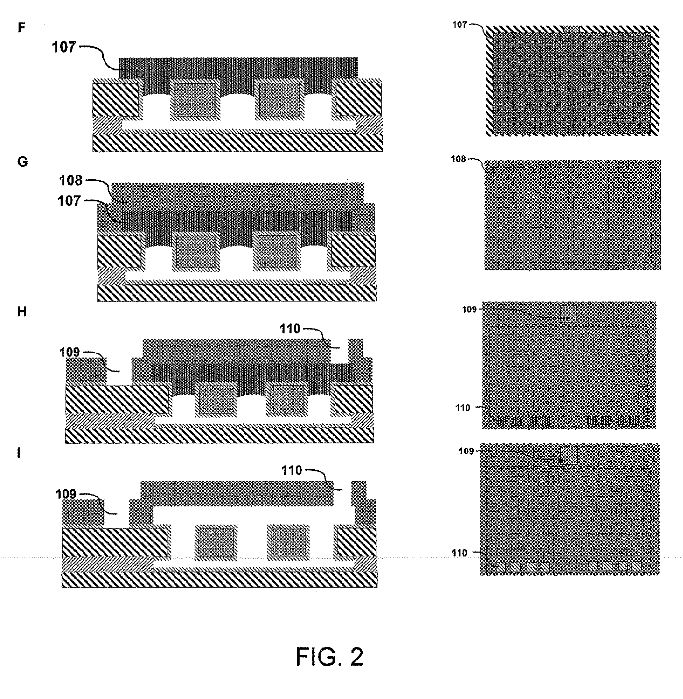

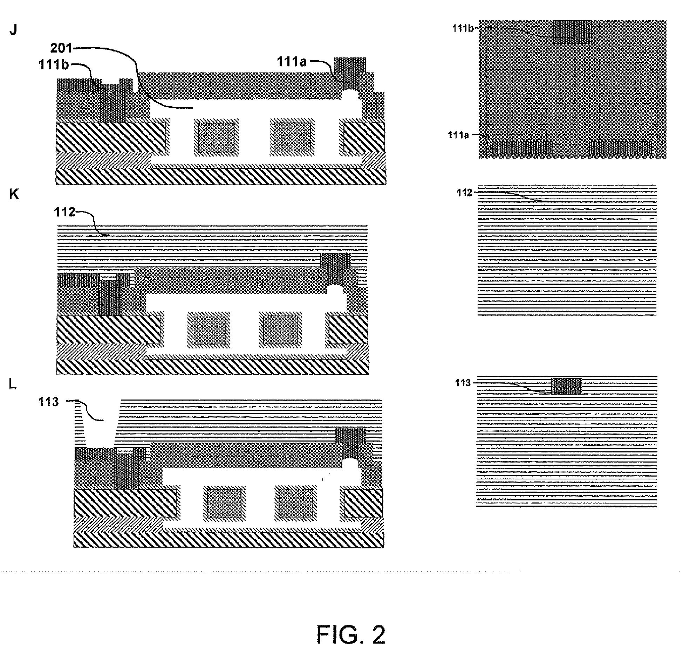

Figure 2 shows a first example of wafer level encapsulation process of the invention.

An example is given in which a so-called "dog bone" resonator is formed (two resonator masses connected by a two parallel spring arms). The figure shows cross-sectional views on the left and plan top views on the right, and represents the fabrication process for thin-film capping. The cross-sectional views correspond to the dashed line in first three plan views, and are taken through the pair of connecting spring arms.

As in Figure 1, the process starts with a Silicon-on-Insulator (SOI) wafer, comprising a monocrystalline silicon substrate 103, SiO₂ layer 102 and silicon layer 101 as shown in Figure 2A.

The substrate 103 provides rigid supports for the entire device structure. It must be thick/rigid enough to provide support. A low thermal expansion coefficient with respect to the active MEMS layer is desirable. Silicon is the dominant industry standard for thin film processing.

The silicon layer 101 is the active MEMS layer, used to define electrically and mechanically the MEMS component. This layer is used to form the free-standing (moving) region of the MEMS device and (at least one of) the actuation electrodes. This layer can also be used to electrically sense motion/displacement in active layer.

The layer 101 must be electrically conducting (to enable actuation). It must be mechanically robust to creep and plastic deformation for example. It must be resistant to etchants used for sacrificial layers used later in the manufacturing process.

The layer 101 is typically silicon (hence a SOI substrate arrangement), but other materials can be used such as Ge, SiC, or combinations of materials.

The layer 102 is a sacrificial/support layer, which supports the active MEMS layer by connection to substrate but is removed where the MEMS component must be released.

This layer 102 must be etched selectively to the active MEMS layer 101, and must not out-gas after a hermetic seal has been applied. In some designs it also needs to be electrically isolating. Typically, SiO₂ or SiN can be used. Both are readily available as the support layer for Si in SOI substrates.

Figure 2B shows the ion implantation of the MEMS layer 101 to form a conductive implanted region 104 using a mask 104'. This region will form the resonator masses and spring arms. The implantation is shown partially complete in Figure 2B.

Figure 2C shows the diffusion and patterning of the MEMS layer 101, in which low resistance portions 105 have been defined. These form the resonator masses and connecting arms.

Figure 2D shows the release etch of the MEMS layer 101, in which released active regions 202 are defined. In the design shown, these are the connection parts. However, in more general terms, these are functional parts of the MEMS component, such as a cantilever switch beam, resonator mass or capacitor electrode. Regions 203 are inactive MEMS regions.

The etch process can use aggressive etchants, such as HF.

Figure 2E shows the formation of a surface passivation and/or temperature compensation layer 106. This can involve oxidization in a furnace to provide an oxidised surface layer. It is well known that a surface oxide layer can be used to provide temperature compensation, in particular by selecting the layer thickness of the Si and SiO₂ layers.

The oxide layer has a positive temperature coefficient of the elastic modulus and can therefore reduce the temperature error.

Figure 2F shows the formation of a second sacrificial layer 107.

This layer defines the cavity region by supporting a subsequent hermetic cap layer (see below) during deposition. This layer must be etched selectively to the active MEMS layer 101 and the hermetic cap layer (discussed below). It needs to provide a continuous upper surface to support the hermetic cap layer, and it must not degrade the material/electrical properties of the active MEMS layer 101 or the hermetic cap layer. Examples of suitable materials are AI, SiO₂, Ti, Ni, Ta, W

The formation of the second sacrificial layer after the formation of the (optional) passivation/temperature-compensation layer allows the temperature compensation layer to be used as an etch stop for the patterning by dry etch of the second sacrificial layer 107. For example, in the case of a metal second sacrificial layer 107 (e.g. AI, Ti, TiN, Ni, Ta, W, WN) stopping on an unoxidised Si active MEMS layer 101 is challenging.

The width of the trenches in the MEMS layer 101 to form the active released regions is limited (for example <2um). In the case of AI used as the second sacrificial layer 107, the grain size of the Al is tuned within a specific range (approximately equal to the trench width) so that the sacrificial layer 107 provides a continuous upper surface to support the hermetic cap layer. No matter what materials are used, the design is such that all trenches in the active MEMS layer 101 that are connected to the cavity region 201 are covered with the sacrificial layer 107 to guarantee continuity of the hermetic cap layer 108 above the cavity region.

Figure 2G shows the application of the hermetic cap layer 108.

This layer defines the cavity region after removal of the underlying sacrificial layer 107. It provides a hermetic seal for the cavity region 201.

For a vacuum packaged device, this layer must be mechanically rigid to sustain 100kPa pressure difference over regions defined by the layer 107. It must not out-gas after deposition of a subsequent hermetic seal layer 111, discussed below. Suitable materials are SiN, SiC, Si, Ge.

Figure 2H shows patterning of the hermetic cap layer 108 to define an electrical contact hole 109 and a hermetic seal hole 110. The etch of the contact 109 and hermetic seal holes 110 can be combined. This simplifies the process.

As shown, the second sacrificial layer 107 and the hermetic seal holes 110 extend sufficiently over the inactive MEMS region 203 (Figure 2D) that the seal hole etch and hermetic layer deposition do not influence the active MEMS regions by, for example, removing or adding material from/to these regions.

Figure 2I shows the second sacrificial etch process, which can be a dry etch process.

Figure 2J shows the deposition of a hermetic seal 111a and an electrical contact metal 111 b.

One material deposition and patterning step can be used to form the hermetic seal layer 111 a and contact metal layer 111 b in order to simplify the process.

The hermetic seal layer 111 a defines the gaseous composition of the cavity 201 during deposition. It can replace layer 108 as the hermetic layer. The seal must be deposited under gaseous atmosphere that is compatible with the requirements of the cavity 201. It must form a continuous hermetic film across the seal regions 110 and must not out-gas under subsequent processing. Suitable materials are AI, Ti, W, AIN, TiN, WN, Si, Ge, SiC.

The electrical contact metal 111 b provides electrical connection to the MEMS structure. It must be highly conducting (with respect to the doped Si regions). Ideally this material provides an appropriate upper surface for direct wire bonding. Suitable materials are AI, Ti, W, AIN, TiN, WN.

Figure 2K shows the deposition of a mechanical support/cap layer 112. This functions as a reinforcement layer in that it provides additional strength to the package.

The reinforcement cap layer 112 provides the mechanical strength required to maintain integrity of the cavity region 201. It must sustain mechanical forces during subsequent processing (e.g. -100MPa during removal of grinding protective tape). Suitable materials are SiN, SiO₂, BPSG, polyimide.

The use of a separate mechanical cap layer means that the layer functionalities of hermeticity and mechanical support are separated between distinct layers that are deposited, respectively, before and after hermetic sealing. The mechanical layer may be permitted to outgas and need not provide a hermetic seal. The hermetic layer need not be very thick and this enables smaller sealing holes that are readily sealed with standard high vacuum deposition techniques (e.g. plasma sputtering).

Figure 2L shows the patterning of the mechanical support layer to define a wire bond opening 113.

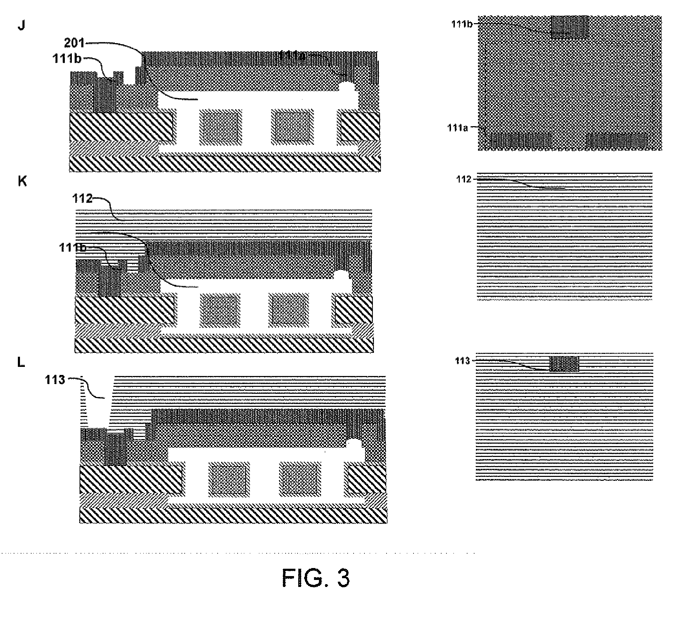

Figure 3 shows a second example of wafer level encapsulation process of the invention.

The steps A to I are the same as in Figure 2, so only steps J to L are shown in Figure 3.

In this version, the functionality of defining the cavity region and providing hermeticity is divided between two distinct layers.

In this case the seal layer 111 a provides, or enhances, the hermeticity and the cover layer 108 serves only to support this layer above the cavity region 201.

In both examples, the combination of the cover layer and the seal layer provide the desired hermetic seal. In Figure 3J, the seal layer 111 a is shown as covering the entire structure, apart from an opening between the cover layer and the electrical contact area 111 b.

The mechanical support layer 112 is deposited (Figure 3K) and patterned (Figure 3L) in the same way as explained above.

The invention can be applied to MEMS devices generally, and not only to resonators as shown. Furthermore, the invention is not limited to SOI substrates.

The invention can be employed in a range of different applications, including pressure sensors, bolometers, displays, gyroscopes, accelerometers.

Other variations to the disclosed embodiments can be understood and effected by those skilled in the art in practicing the claimed invention, from a study of the drawings, the disclosure, and the appended claims. In the claims, the word "comprising" does not exclude other elements or steps, and the indefinite article "a" or "an" does not exclude a plurality. The mere fact that certain measures are recited in mutually different dependent claims does not indicate that a combination of these measured cannot be used to advantage. Any reference signs in the claims should not be construed as limiting the scope.

## Claims

1. A method of manufacturing a MEMS device, comprising:
forming a MEMS device element by:
forming and patterning a MEMS layer (101) over a sacrificial support layer (102) to define a component of the MEMS device which is to be suspended; and
performing a first sacrificial etch to release the MEMS component (105) by removing the sacrificial support layer (102) beneath the MEMS component;
depositing a sacrificial cover layer (107) over the MEMS device element;
depositing and patterning a cover layer (108) over the sacrificial cover layer (107);
performing a second sacrificial etch to remove the sacrificial cover layer (107) through at least one opening (110) in the cover layer (108); and
closing the at least one opening (110) in the cover layer (108) thereby defining a hermetic cover.

2. A method as claimed in claim 1, wherein the MEMS layer (101) and sacrificial support layer (102) are provided over a substrate (103), wherein the MEMS layer (101), sacrificial support layer (102) and substrate (103) together define a SOI substrate arrangement.

3. A method as claimed in claim 2, wherein the sacrificial support layer (102) comprises SiO₂ or SiN.

4. A method as claimed in any preceding claim, wherein the sacrificial cover layer (107) comprises Al, SiO₂, Ti, TiN, Ni, Ta W or WN.

5. A method as claimed in any preceding claim, further comprising applying or forming a layer (106) on the released MEMS component before depositing the sacrificial cover layer (107).

6. A method as claimed in claim 5, wherein the applied or formed layer (106) comprises an oxide layer for passivation and/or temperature compensation of the MEMS component.

7. A method as claimed in any preceding claim, further comprising depositing a reinforcement cap layer (112) over the cover layer (108) after closing the at least one opening (110) in the cover layer (108).

8. A method of manufacturing a MEMS device, comprising:
forming a MEMS device element;
depositing a sacrificial cover layer (107) over the MEMS device element;
depositing and patterning a cover layer (108) over the sacrificial cover layer (107);
performing a second sacrificial etch to remove the sacrificial cover layer (107) through at least one opening (110) in the cover layer (108);
closing the at least one opening (110) in the cover layer (108) thereby defining a hermetic cover; and
depositing a reinforcement cap layer (112) over the cover layer (108) after closing the at least one opening (110) in the cover layer (108).

9. A method as claimed in any preceding claim, wherein the cover layer (108) comprises SiN, SiC, Si or Ge.

10. A method as claimed in any preceding claim, wherein closing the at least one opening (110) in the cover layer (108) comprises depositing a hermetic seal layer of AI, Ti, W, AIN, TiN, WN, Si, Ge or SiC.

11. A method as claimed in claim 10, wherein depositing the hermetic seal layer also defines electrical contact regions to the MEMS device element, and the seal layer comprises Al, Ti, W, AIN, TiN, or WN.

12. A method as claimed in any one of claims 7 to 11, wherein the reinforcement cap layer comprises SiN, SiO₂ BPSG or polyimide.

13. A method as claimed in any preceding claim, wherein the MEMS device element (12) comprises a switch, capacitor or resonator.

14. A MEMS device, comprising:
a MEMS device element;
a cover layer (108) over the MEMS device element, with a MEMS device element in a chamber beneath the cover layer (108), wherein the cover layer has at least one closed opening (110) such that the cover layer (108) and closed opening defines a hermetic cover; and
a reinforcement cap layer (112) over the cover layer (108).
